Europäisches Patentamt

European Patent Office

Office européen des brevets

(11) Veröffentlichungsnummer: **0 158 181**
**B1**

# EUROPÄISCHE PATENTSCHRIFT

(45) Veröffentlichungstag der Patentschrift:
16.09.87

(51) Int. Cl.⁴: **C 30 B 15/00**, C 30 B 15/06

(21) Anmeldenummer: 85103257.3

(22) Anmeldetag: 20.03.85

(54) Verfahren zum Herstellen von rissfreien, grossflächigen Siliziumkristallkörpern für Solarzellen.

(30) Priorität: 09.04.84 DE 3413355

(43) Veröffentlichungstag der Anmeldung:
16.10.85 Patentblatt 85/42

(45) Bekanntmachung des Hinweises auf die Patenterteilung:
16.09.87 Patentblatt 87/38

(84) Benannte Vertragsstaaten:
DE FR GB IT

(56) Entgegenhaltungen:
DE - A - 3 010 557
DE - A - 3 226 931
DE - A - 3 231 326

(73) Patentinhaber: Siemens Aktiengesellschaft Berlin und München, Wittelsbacherplatz 2, D-8000 München 2 (DE)

(72) Erfinder: Bernewitz, Lore, Wilhelm-Diessweg 9,
D-8000 München 81 (DE)
Erfinder: Falckenberg, Richard, Dr., Hofen 21,
D-8952 Wald (DE)
Erfinder: Hoyler, Gerhard, Dipl.-Phys., Münchberger Strasse 11a, D-8000 München 90 (DE)
Erfinder: Grabmaier, Josef, Dr., Am Seefeld 17,
D-8137 Starnberg 1 (DE)

# Beschreibung

Die Erfindung betrifft ein Verfahren zum Herstellen von rissfreien, quasi-monokristallinen, grossflächigen Siliziumkristallkörpern für Solarzellen durch kontinuierliches Beschichten eines flächenförmigen, eine netzartige Struktur aufweisenden Trägerkörpers aus einem Carbonfasergewebe, bei dem das schmelzflüssige Silizium mit dem Trägerkörper in Kontakt gebracht wird und bei der Kristallisation des Siliziums der Trägerkörper in den Siliziumkörper integriert wird.

Ein solches Verfahren ist beispielsweise aus der DE-OS 3 010 557 A1 bekannt. Hier wird ein Verfahren zur Herstellung von Flächensilizium bei hohem Durchsatz ($\sim 1$ m²/min) für Solarzellen beschrieben, bei dem die Beschichtung in bezug auf die Ziehgeschwindigkeit so geführt wird, dass sich aufgrund der hohen Oberflächenspannung des geschmolzenen Siliziums in den Maschen des Netzes eine dünne Siliziumschicht ausbildet, so dass nach dem Erstarren das aus den Fasern bestehende Netzwerk in den Siliziumkörper integriert ist. Bei der Beschichtung wird der Trägerkörper durch eine spaltförmige Öffnung im Boden einer Schmelzwanne gezogen. Der Trägerkörper kann aber auch tangierend über die Oberfläche der in einer Wanne befindlichen Siliziumschmelze gezogen werden, wie es beispielsweise aus der DE-OS 2 850 805.6 bekannt ist.

Die Aufgabe, die der Erfindung zugrundeliegt, besteht in der Verbesserung der bekannten Verfahren in bezug auf die Benetzbarkeit des Trägerkörpers mit flüssigem Silizium.

Die Benetzbarkeit des als Trägerkörper verwendeten Carbonfasergewebes mit schmelzflüssigem Silizium hängt von der Vorbehandlung des Gewebes ab und wirkt sich stark auf die Eigenschaften des entstehenden Flächensiliziums aus. So erhält man bei schlecht benetzendem Carbonfasergewebe Flächensilizium mit Mikrorissen, welches zur Herstellung von Solarzellen nicht brauchbar ist. Die Entstellung dieser Mikrorisse wird auf den Unterschied der thermischen Ausdehnungskoeffizienten von Silizium und Kohlenstoff-Fasern zurückgeführt. So beträgt der thermische Ausdehnungskoeffizient $\alpha \times 10^6/°K$ bei $T \sim 300°K$ für Silizium $+2,3$, für Carbonsäuren parallel zur Faserrichtung $-0,6$, für Carbonfasern senkrecht zur Faserrichtung $+5$ und für Siliziumcarbid $+3,1$.

Der Unterschied im thermischen Ausdehnungskoeffizienten kommt bei schlechter Benetzung voll zum Tragen. Bei guter Benetzung reagieren die am Faserstrang aussenliegenden und oberflächennahen Filamente völlig, die weiter innen im Strang liegenden Filamente zum grossen Teil zu Siliziumcarbid. Da der Ausdehnungskoeffizient von Siliziumcarbid, wie oben gezeigt, dem des Silizium sehr nahekommt, sind die bei der Abkühlung entstehenden Spannungen gering und können keine Risse in der Oberfläche mehr verursachen.

Die Erfindung macht sich diese Erkenntnis zunutze und löst die oben gestellte Aufgabe der Verbesserung der Benetzung dadurch, dass der aus dem Carbonfasergewebe bestehende Trägerkörper vor der Siliziumbeschichtung zumindest in den für die Beschichtung vorgesehenen Bereichen einer aktivierenden Oberflächenbehandlung in der Weise unterzogen wird, dass nicht abgesättigte C-Bindungen an der Oberfläche entstehen. Dabei liegt es im Rahmen der Erfindung, dass die aktivierende Oberflächenbehandlung entweder durch eine Temperaturbehandlung im Bereich von 2500°C in einer strömenden Halogengas- oder Edelgasatmosphäre durchgeführt wird und/oder durch Glühen des Carbonfasergewebes in einer Wasserstoff/-Sauerstoff-Flamme an Luft und/oder durch Aussetzen des Carbonfasergewebes einer Corona-Entladung in Luft vorgenommen wird.

Durch die Erfindung ist die Möglichkeit gegeben, die Oberfläche des Trägerkörpers partiell zu aktivieren, das heisst, sich auf solche Flächen zu beschränken, auf denen eine Beschichtung erwünscht ist und Bereiche unbehandelt zu lassen, die nicht beschichtet werden sollen. Solche Bereiche sind die Netzränder sowie die Streifen, die zur Trennung des beschichteten Gewebes in die einzelnen, für die Weiterverarbeitung zu Solarzellen vorgesehen Siliziumplatten, erforderlich sind.

Da die Oberflächenaktivierung eines Carbonfasergewebes wegen der Absättigung der freien C-Bindungen nicht über längere Zeiträume erhalten bleibt, ist gemäss einem Ausführungsbeispiel nach der Lehre der Erfindung vorgesehen, den Aktivierungsprozess zu wiederholen.

## Patentansprüche

1. Verfahren zum Herstellen von rissfreien, quasi-monokristallinen grossflächigen Siliziumkristallkörpern für Solarzellen durch kontinuierliches Beschichten eines flächenförmigen, eine netzartige Struktur aufweisenden Trägerkörpers aus einem Carbonfasergewebe, bei dem das schmelzflüssige Silizium mit dem Trägerkörper in Kontakt gebracht wird und bei der Kristallisation des Siliziums der Trägerkörper in den Siliziumkörper integriert wird, dadurch gekennzeichnet, dass zur Verbesserung der Benetzbarkeit der aus dem Carbonfasergewebe bestehende Trägerkörper vor der Siliziumbeschichtung zumindest in den für die Beschichtung vorgesehenen Bereichen einer aktivierenden Oberflächenbehandlung in der Weise unterzogen wird, dass nicht abgesättigte C-Bindungen an der Oberfläche entstehen.

2. Verfahren nach Anspruch 1, dadurch gekennzeichnet, dass als aktivierende Oberflächenbehandlung eine Temperaturbehandlung im Bereich von 2500°C in einer strömenden Halogengas- oder Edelgasatmosphäre durchgeführt wird.

3. Verfahren nach Anspruch 1 und/oder 2, dadurch gekennzeichnet, dass zur aktivierenden Oberflächenbehandlung das Carbonfasergewebe in einer Wasserstoff/Sauerstoff-Flamme an Luft geglüht wird.

4. Verfahren nach mindestens einem der Ansprüche 1 bis 3, dadurch gekennzeichnet, dass zur aktivierenden Oberflächenbehandlung das Carbonfasergewebe einer Corona-Entladung in Luft ausgesetzt wird.

5. Verfahren nach mindestens einem der Ansprüche 1 bis 4, dadurch gekennzeichnet, dass der Aktivierungsprozess wiederholt wird.

## Claims

1. A process for the production of crack-free, quasi-monocrystalline, large-surface silicon crystal bodies for solar cells by continuously coating a flat carrier body which has a lattice-like structure and is made from a carbon fibre fabric, in which the molten silicon is brought into contact with the carrier body and, during the crystallisation of the silicon, the carrier body is integrated into the silicon body, characterised in that in order to improve the wettability, before the coating with silicon, the carrier body made from the carbon fibre fabric is subjected at least in those areas provided for the coating, to an activating surface treatment such that unsaturated C-bonds occur at the surface.

2. A process as claimed in Claim 1, characterised in that a heat treatment in the region of 2500°C in a flowing halogen gas or rare gas atmosphere is carried out as activating surface treatment.

3. A process as claimed in Claim 1 and/or 2, characterised in that the carbon fibre fabric is annealed in a hydrogen/oxygen flame in the presence of air as activating surface treatment.

4. A process as claimed in at least one of Claims 1 to 3, characterised in that the carbon fibre fabric is exposed to a corona discharge in the presence of air as activating surface treatment.

5. A process as claimed in one of Claims 1 to 4, characterised in that the activation step is repeated.

## Revendications

1. Procédé pour fabriquer des corps en cristal de silicium quasi-monocristallin, de surface étendue et sans fissures pour des piles solaires, par enduction continue d'un corps de support en forme de nappe, possédant une structure en forme de réseau et constituée par un tissu formé de fibres de carbone, et selon lequel le silicium fondu est amené en contact avec le corps de support et, lors de la cristallisation du silicium, le corps de support est intégré au corps en silicium, caractérisé par le fait que pour améliorer la mouillabilité, on soumet, avant le dépôt du silicium, le corps de support constitué par le tissu formé de fibres de carbone à un traitement de surface produisant une activation, au moins dans les zones prévues pour le dépôt, de telle sorte qu'il n'apparaît pas de liaisons C saturées au niveau de la surface.

2. Procédé suivant la revendication 1, caractérisé par le fait qu'on exécute, comme traitement de surface produisant une activation, un traitement thermique dans une zone située à 2500°C, dans une atmosphère en écoulement de gaz halogène ou de gaz rare.

3. Procédé suivant la revendication 1 et/ou 2, caractérisé par le fait que pour réaliser le traitement de surface produisant une activation, on porte à incandescence le tissu formé de fibres de carbone dans une flamme à l'hydrogène/oxygène dans l'air.

4. Procédé suivant au moins l'une des revendications 1 à 3, caractérisé par le fait que pour réaliser le traitement de surface produisant une activation, on soumet le tissu de fibres de carbone à une décharge par effet couronne dans l'air.

5. Procédé selon au moins l'une des revendications 1 à 4, caractérisé par le fait que le processus d'activation est répété.